# EUROPEAN PATENT APPLICATION

(11) **EP 4 641 426 A1**
(43) Date of publication of application: **29.10.2025**
(21) Application number: 24172698.3
(22) Date of filing: 26.04.2024
(51) Int. Cl.: G06F 30/13, G06T 17/10

(54) **INVERT SPACES**

(71) Applicant: Bricsys NV, 9050 Gent (Ledeberg) (BE)
(72) Inventor: Lelieur, Piet, 9090 Melle (BE); Nys, Wouter, 8670 Koksijde (BE); Vancroonenburg, Wim, 9940 Evergem (BE); Mulkers, Jeroen, 9000 Gent (BE)
(74) Representative: IP HILLS NV

(57) **Abstract**

A computer implemented method for generating building elements from a set of piecewise planar objects that are obtained from scanning data from room interiors within a building. This method allows for the automatic generation and classification of building elements from a set of room interior representations, enabling an efficient modelling process in architectural and construction projects.

## Description

### Technical Field

The present invention generally relates to the field of CAD or computer aided design for infrastructure design and construction, i.e. the design of houses, buildings, bridges, pipelines and equipment. More specifically does it relate to the automated generation and classification of solids that represent the building elements of a building such as walls, floors, roofs and beams. The method uses interior room solids as input that are acquired by scanning different corresponding rooms of an architectural shape. The solids are generated based on imperfect scanned data of an architectural shape into a model that can be used in CAD or computer aided design.

### Background

The automated reconstruction of 3D models from acquired data, be it images or 3D point clouds obtained through scanning, has been one of the central topics in computer graphics and computer vision for decades. Reconstructing and modelling the as-built architectural shape of building interiors has emerged in recent years as an important and challenging research problem. An effective approach must be able to faithfully capture the architectural structures and separate permanent components from clutter (e.g. furniture), while at the same time dealing with defects in the input data.

The automated process of automatically modelling building elements from scanned room data is complex and involves several steps. A first step is typically a data acquisition step wherein scanned room data is typically obtained through technologies such as LiDAR (Light Detection and Ranging) or photogrammetry. These methods capture detailed 3D point cloud data of the room, including surfaces of walls, floors, ceilings, and other objects. The raw point cloud data may require preprocessing to remove noise, outliers, and irrelevant points. This step typically ensures that the data is clean and suitable for further analysis.

In a further step, a segmentation may for instance be performed that involves dividing the point cloud data into meaningful segments or clusters representing different objects or surfaces within the room. Various algorithms such as region growing, clustering, or plane fitting can be used for segmentation. Walls, floors, and roofs are typically identified as large planar surfaces within the point cloud.

Various methods have been proposed to segment different building elements from a point cloud, such as for instance region growing, plane fitting, clustering or alike. These methods can be used individually or in combination, depending on the characteristics of the point cloud data and the specific segmentation requirements. In practice, a hybrid approach that combines multiple techniques often yields the best results for segmenting different building elements from point cloud data. However, most of the proposed methods require manual adaptations to the outputted result in order to achieve an acceptable result. Errors may quickly arise when the point cloud data for instance suggest that certain room surfaces are not 100% parallel or when small inclusions seem to be present in the scanned data.

It is therefore an object of the invention to provide a method for reliably generating and classifying general 3D architectures into simplified high-level structured models.

### Summary

The following is a summary of the invention in order to provide a basic understanding of some aspects of the invention. This summary is not intended to identify key or critical elements of the invention or to delineate the scope of the invention. The sole purpose of this section is to present some concepts of the invention in a simplified form as a prelude to the more detailed description that is presented later. The scope of protection sought for various embodiments of the invention is set out by the independent claims.

To this aim, according to a first aspect of the invention, there is provided a computer implemented method for generating and classifying building elements from a set of piecewise planar objects that are obtained from room interiors of a building, comprising the steps of growing said piecewise planar objects by extruding the planes of said piecewise planar objects with a user defined thickness, obtaining a fused piecewise planar object by creating a union of said grown piecewise planar objects representing said room interiors, obtaining a cell complex comprising cells that are obtained by intersecting said fused piecewise planar object with intersecting planes that are obtained by extending all planes of said piecewise planar objects and all planes of said fused piecewise planar object, classifying each cell of said cell complex as a solid cell on condition that said cell is not located within one of said piecewise planar objects, and merging said solid cells into said building elements.

Solid modelling in CAD (Computer-Aided Design) is a method of creating digital representations of three-dimensional objects or shapes with a volume and mass. It involves using mathematical and geometric concepts to define solid objects in a virtual environment within CAD software. Especially deriving such solid models from existing structures that are obtained from scanned data and entering them into a CAD system for further manipulation is not trivial.

Solid modelling differs from other modelling techniques, such as surface modelling or wireframe modelling, in that it explicitly represents the volume and shape of an object. Instead of just representing the surface or edges of an object, solid modelling captures the interior as well, allowing for more accurate and realistic representations.

In solid modelling, objects are typically created by combining basic geometric primitives (such as cubes, cylinders, spheres) or by using advanced modelling features like extrusion, revolve, sweep, loft, and blend operations. These operations allow designers and engineers to create complex shapes by manipulating basic building blocks or by modifying existing shapes.

Solid modelling is widely used in various industries such as mechanical engineering, product design, architecture, aerospace, automotive, and manufacturing. It enables designers and engineers to visualize, analyze, simulate, and prototype designs digitally before they are manufactured, helping to reduce development time and cost while improving the overall quality of the final product. Building solids in CAD (Computer-Aided Design) refer to the creation of three-dimensional objects or shapes using solid modelling techniques within CAD software. Building solids involves creating geometric shapes such as cubes, cylinders, spheres, cones, and more complex shapes by combining primitive shapes or using features like extrusion, revolve, loft, sweep, and boolean operations like union, difference, and intersection.

CAD software allows designers, engineers, and architects to create detailed and precise representations of objects or structures digitally. Building solids in CAD are essential elements for various industries such as architecture, mechanical engineering, product design, and manufacturing, as they enable the visualization, analysis, and modification of designs before they are physically constructed.

The method of the invention models solids of building elements that represent the essential building blocks or building elements of an existing construction. The method tries to obtain, generate or extract information from a set of measurements performed in the existing construction, in order to turn the information into a set of well-delineated solids of building elements. The method therefore automates the extraction of building solids from a dataset that is obtained through measurement of a set of room interior spaces. The method performs a conversion of pre-processed data that is available as a set of piecewise planar objects representing the room interiors of a building into a collection of solids representing building elements of the same building. A usable method producing a set of piecewise planar objects based on 3D room interior measurements is disclosed in European Patent Application EP24163343.7, which is hereby incorporated by reference.

A high quality extraction of these essential building elements of a structure improves the process of evaluating and applying any subsequent modifications to the existing building structure in a CAD system, and speeds up the modelling process in general. The technical problem solved by the invention is to provide an accurate conversion of a set of room interior spaces into a set of building elements that make up said room interior spaces.

The essential building elements comprise exterior walls, interior walls, floors, roofs and ceilings. Modelling is the process of creating a representation or simulation of something, often in a simplified or scaled-down form, in order to understand or predict its behaviour, appearance, or characteristics. In the invention, the representation is a digital representation of the building elements as solids. A solid refers to a three-dimensional geometric object or shape that has volume and mass. It is a fundamental building block used in CAD software to represent physical objects or components digitally.

The ability to correctly and accurately model the existing building elements allows these elements to be introduced as solids into a CAD system. A fast and reliable generation of these building elements into a CAD system is a prerequisite to allow a user to optimize and simulate adaptations to the existing structures. These optimizations and adaptations can be performed accurately in software only on condition that the solids accurately represent their real-world counterparts. Accurately representing means in the context of the invention that the solids are an accurate geometrical representation of a building element, but also that these elements are correctly classified accordingly. All delineated building elements that are represented as solids in the 3D model have to be accurately identified and classified as one of the essential building elements. Each identified solid therefore has to correctly correspond to an interior wall, an exterior wall, a roof or a floor. The correct identification or classification allows further in the process that certain characteristics may be uniformly attributed to the solid. These characteristics may be material choices, material thicknesses, or alike.

Architects and engineers can analyse various design parameters for added and adapted structures or building elements. They can simulate different positioning conditions and material selections, and iterate rapidly to find the optimal design that for instance minimizes building costs and maximizes building quality.

The method of the invention uses a collection of shapes representing the interiors of the different rooms of a building as input. These shapes representing the rooms are preferably piecewise planar objects. Piecewise planar object refers to a three-dimensional geometric object that can be approximated or represented as a collection of planar surfaces or facets. Instead of being perfectly smooth or continuously curved, the surface of such an object consists of flat planes that are joined together at edges. Piecewise planar objects are commonly used in computer graphics, computer-aided design (CAD), and geometric modelling to approximate complex shapes with simpler geometric primitives. This representation simplifies the modelling process and facilitates various computational operations such as rendering, collision detection, and geometric analysis.

For example, in CAD software, a piecewise planar representation might be used to approximate the surface of a building, where the overall shape is composed of planar surfaces that are stitched together to form the complete object. Similarly, in computer graphics, piecewise planar modelling can be employed to create objects with faceted appearances, such as low-polygon models used in real-time rendering applications or for 3D printing. Piecewise planar modelling strikes a balance between simplicity and accuracy, allowing for efficient representation and manipulation of complex shapes while providing a reasonable approximation of their geometric properties.

The shapes of the room interiors are indirectly obtained from measured data, such as for instance a point cloud of a building interior, which may be the point cloud of the interior of a room, or a collection of rooms. The point cloud is sampled from a real-world environment that could be captured by various means (e.g., drones, handheld scanners, lidar systems and depth cameras) and which are enriched with their point normal data. Known methods may transform these point data into piecewise planar objects, in that case representing the room interior volumes of the measured rooms. It is exactly these room volumes that are used as input for the method of the invention.

The method of the invention grows the piecewise planar objects by extruding its planes with a user defined thickness. In the context of the invention, the overall method involves taking a set of 2D planes or surfaces that define an object, and creating a 3D model of that object by extruding the planes or surfaces in a direction perpendicular to their surface with a user-defined thickness. The resulting 3D model is made up of a set of connected, piecewise planar objects that have been extruded to a specified thickness. The advantage of this step is that the resulting connected piecewise planar objects can be fused together to form a single fused piecewise planar object encapsulating the entire building.

In a next step, will the fused piecewise planar object be split into a high number of cells by intersecting it with planes that are obtained by extending all planes of the piecewise planar objects and all planes of the fused piecewise planar object. The technical effect of this method step is that the large fused piecewise planar object is split into a high number of apparently randomly created cells, for which it has to be understood that any to-be-determined building element will consist of a limited number of said cells that are classified as solid cells and which are obtained through a classification step. Merging the cells that are at least classified as solid cells will result in the generation of the building elements.

According to a second example aspect a method is disclosed comprising a step for classifying the solid cells as a member of an exterior shell of said building, on condition that an orthogonal distance between a geometric centre of said solid cell and a plane of the fused piecewise planar object does not exceed the user defined thickness. This classification step ensures that only the building elements that are located at the outside of the building are identified. The cells that are classified as such are part of an exterior shell building element.

According to another example aspect of the invention a method is disclosed further comprising a step to further classify the solid cells of said exterior shell building element as a member of said exterior building elements as vertical exterior wall element of said building, on condition that said solid cell shares an exterior face with the fused piecewise planar object and that the exterior face is oriented vertically. After the classification as being part a vertical exterior wall element, the solid cells are merged into such a vertical exterior wall element. The technical effect of this step is to further classify the exterior shell building elements as vertical exterior wall elements.

Similarly, and according to a further example aspect of the invention a method is disclosed further comprising a step to classifying each of said solid cells of said exterior shell building element as a member of a roof element of said building, on condition that the solid cell shares an exterior face with the fused piecewise planar object and that the exterior face is oriented upwards. After the classification as being part a roof element, the solid cells are merged into such a roof element. The technical effect of this step is to further classify the exterior shell building elements as roof elements.

Similarly, and according to a further example aspect of the invention a method is disclosed further comprising a step to classifying each of the solid cells that are not classified as an exterior shell building element as a member of a horizontal slab element of said building, on condition that the solid cell shares an upper face with a lower horizontal plane of a piecewise planar object, or that the solid cell shares a lower face with an upper horizontal plane of a piecewise planar object.

According to yet a further example aspect of the invention a method is disclosed further comprising a step to classifying each of the solid cells that are neither classified as an exterior shell building element, nor as horizontal slab element as a member of an interior wall element of said building, on condition that the solid cell is located between vertical faces of the two of the original piecewise planar objects.

Another further example aspect of the invention provides a method that classifies a number of interior wall elements as being part of a same interior wall by calculating a connectivity graph wherein the faces of the corresponding piecewise planar objects that are contributing to the interior wall elements are represented as nodes, and wherein these nodes are connected by an edge on condition that said faces are parallel, partially overlapping, and not further apart from each other than two times said user defined thickness. The considered interior wall elements are classified as being part of a same interior wall on condition that their geometric center is located between any pair of faces of piecewise planar objects which are interconnected by edges in said connectivity graph.

In a final example aspect of the invention, the remaining and unclassified solid cells are being further attributed to any of the earlier classified building elements by attributing the considered solid cell to one of said interior wall elements by performing a depth-first search that is initiated from a neighbouring interior wall element in the direction of the considered solid cell, and wherein the depth-first search being performed in a horizontal direction.

The technical advantage of the invention is that in comparison with methods in the art, that were mainly based on plane-fitting methods for the building elements, the fitted results are much more accurate. Earlier methods described in the art typically were based on the expected thickness of the walls and fitted these walls into the space that was available between rooms. This method lead to inaccuracies, because walls were always assumed to be perfect in thickness, shape and orientation, which is not always the case.

### Brief Description of the Drawings

Some example embodiments will now be described with reference to the accompanying drawings.
Fig. 1 shows a flow chart representing the method for generating building elements from a set of piecewise planar objects that represent the room interiors of a single building, the flow chart comprises the different steps;
Fig. 2 shows a flow chart representing the classification steps of the method of the invention;
Fig. 3 shows a set of piecewise planar objects that represent the room interiors of a single building, and that is used as the input for the method of the invention;
Fig. 4 shows a concave inflated union of the set of piecewise planar objects that represent the room interiors of a single building; the drawing shows a fused piecewise planar object obtained by creating the union of said grown piecewise planar objects representing said room interiors;
Fig. 5 illustrates the same fused piecewise planar object as in Fig. 4 after being intersected by intersecting planes that are obtained by extending all planes of said piecewise planar objects and all planes of said fused piecewise planar object.
Fig. 6 shows the concave inflated union of the set of piecewise planar objects stripped from its exterior shell;
Fig. 7 shows the fused piecewise planar object indicating different types of building elements with different shadings;
Fig. 8 shows the solids cells that remain after removing the original piecewise planar objects from the concave inflated union of the set of piecewise planar objects that is stripped from its exterior shell, horizontal slabs and internal walls;
Fig. 9 illustrates a data processing apparatus that is suited for executing the method of the invention.

### Detailed Description of Embodiment(s)

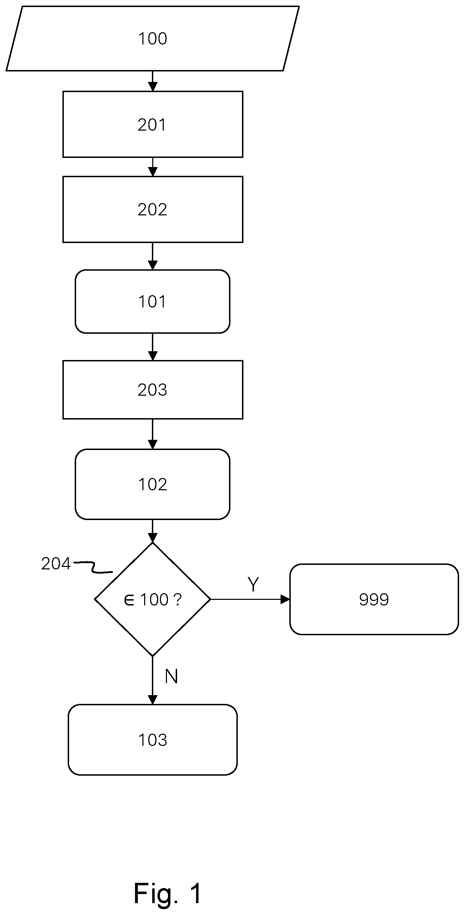

Fig. 1 is a flowchart that gives an overview of the steps of the method of the invention. The steps of the method may be executed in a CAD software, for instance as part of a Scan-to-BIM module. CAD (Computer-Aided Design) software is designed to handle a variety of geometric primitives and shapes, including planes, lines, curves, and solids. CAD software allows users to create, modify, analyse, and visualize 2D and 3D models for various engineering, architectural, and design purposes. Scan-to-BIM or Reality Capture is the process of extracting building elements from a 3D scan of a building and converting it into an intelligent, parametric BIM model for various applications in architecture, engineering, and construction.

The method of the invention requires that the 3D scan data have been pre-processed into a geometric object for each room interior of the building. Each room interior is represented by a piecewise planar object, and these piecewise planar objects are then used as input 100 for the method of the invention. A practical method producing a set of piecewise planar objects based on 3D room interior measurements is disclosed in European Patent Application EP24163343.7. A piecewise planar object refers to a three-dimensional object or surface that is composed of individual planar regions, where each region is flat or nearly flat. In other words, the overall object can be approximated or represented as a collection of interconnected planar surfaces. The term piecewise indicates that the object is divided into distinct pieces or segments, and planar indicates that each of these pieces is flat.

The method creates new 3D volumes from each of the piecewise planar objects 100 representing the room interiors by extending each surface of each piecewise planar object 100 in a direction perpendicular to their surface. The perpendicular growing or extrusion 201 is done with a user defined thickness. The user defined thickness means that the user can specify the distance by which the planes or surfaces should be extruded, i.e., the thickness by which all piecewise planar objects 100 are extruded of the resulting 3D object.

The extruded objects then are fused 202 to form a single fused piecewise planar object 101 for each separate building. This fused piecewise planar object represents a union of said grown piecewise planar objects representing said room interiors.

In a next step of the method, the fused piecewise planar object is intersected 203 by a multitude of planes 301 to form a cell complex 102. The fused piecewise planar object 101 is thus cut into a multitude of smaller cells by a number of intersecting planes 301, allowing further method steps to process the cells individually. The fused piecewise planar object 101 is intersected by planes that align with the faces of the different piecewise planar objects 100, including the faces from the fused piecewise planar object 101. The planes are thus defined by the orientation of the faces of the different piecewise planar objects 100, including the faces from the fused piecewise planar object 101. Additional planes that further intersect the fused piecewise planar object 101 may be selected arbitrarily, and this selection may further improve the outcome of the classification.

In a next step of the method 204, all cells in the cell complex 102 are evaluated whether or not they belonged to the volume of one of the original piecewise planar objects 100 that defined the room interior volumes. All cells in the cell complex 102 that fitted any of said original input volumes 100 are further discarded in the next method steps, or are classified as cells that are part of a room interior volume, named room interior cells 999.

A first level of classification of the cells is achieved by determining whether a cell of the cell complex 102 was not part of any of the measured room interior volumes 100 represented as piecewise planar objects. In the latter case where a cell of the cell complex 102 is not part of the room interior volume, this cell is classified as a solid cell 103. In other words, the remaining volume of the fused piecewise planar object 101 after subtraction of the room interior volumes 100 that are represented as piecewise planar objects, represent all solids of the building. This collection of solids of the building consist of the classified solids cells 103 obtained in the classification step 204 of the method.

The classified solid cells 103 may then be further classified 205 according to criteria such as their relative position and be merged together to contribute to a building element. The essential building elements comprise exterior walls, interior walls, floors, roofs and ceilings.

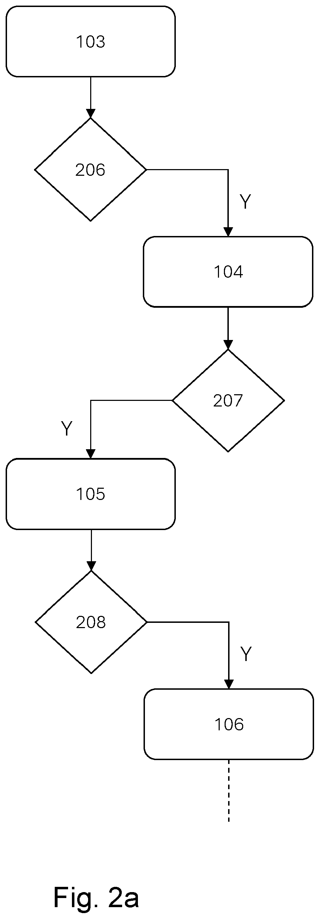

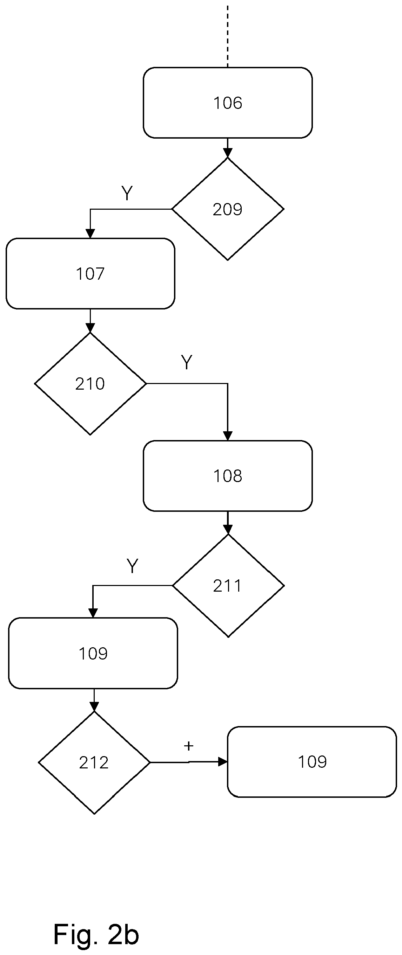

Fig. 2a provides another flow chart representing further method steps captured in the dependent claims. Fig. 2b is a continuation of the method depicted in Fig. 2a.

In a next step 206, the solid modelling approach is further refined to generate and classify the exterior shell of the building. Each classified solid cell 103 is further classified as a member of the exterior shell of the building, named exterior shell solid cells 104, if the orthogonal distance between the geometric centre of the solid cell 103 and a plane of the fused piecewise planar object 101 does not exceed the user-defined thickness. The exterior shell solid cells 104, solid cells that are classified as members of the exterior shell of the building are merged into an exterior shell building element.

These additional steps allow for the identification and separation of the exterior shell building elements from other internal building elements. This differentiation is crucial for various applications in architecture, engineering, and construction, such as energy performance analysis, structural analysis, and fagade design. By generating a well-defined exterior shell, professionals can better assess and optimize the building's envelope for thermal performance, daylighting, and other essential factors.

In a next step 207 the solid modelling approach is further refined to generate and classify vertical exterior wall elements of the building starting from the exterior shell solid cells 104. Each exterior shell solid cell 104, which is a solid cell of an exterior shell building element, is classified as a member of a vertical exterior wall element, named vertical wall solid cell 105, if the solid cell 104 shares an exterior face with the fused piecewise planar object and the exterior face is oriented vertically. The vertical wall solid cells 105 are merged into a vertical wall building element.

These additional steps allow for the identification and separation of vertical exterior wall elements from the rest of the exterior shell and other building elements. This differentiation is essential for various applications in architecture, engineering, and construction, such as structural analysis, envelope design, and energy performance optimization. By generating well-defined vertical exterior wall elements, professionals can better assess and optimize the building's fagade for factors like thermal performance, wind resistance, and daylighting. Additionally, this information can be valuable for designing and detailing cladding systems, windows, and other vertical wall components.

In a further step 208, is the solid modelling method further refined to generate and classify roof elements of the building. Each solid cell of the exterior shell building element, that is not classified as a vertical wall solid cell 105, is classified as a member of a roof element, named roof element solid cell 106, if the solid cell shares an exterior face with the fused piecewise planar object 101 and the exterior face is oriented upwards. The roof element solid cells 106 are merged into a roof element.

These additional steps allow for the identification and separation of roof elements from the rest of the exterior shell and other building elements. This differentiation is crucial for various applications in architecture, such as structural analysis, envelope design, and energy performance optimization. Additionally, this information can be valuable for designing and detailing roofing systems, skylights, and other roof components.

Fig 2b, further illustrates by means of a flow chart the sequence of steps that are further performed in the method. In a further step 209, the method of the invention is further refined to generate and classify horizontal slab elements of the building. Each solid cell that is not classified as an exterior shell building element, is classified as a member of a horizontal slab element, named a horizontal slab solid cell 107, on condition that the solid cell 107 shares an upper face with a lower horizontal plane of a piecewise planar object 100 or shares a lower face with an upper horizontal plane of a piecewise planar object 100. The horizontal slab solid cells 107 are subsequently merged into a horizontal slab element.

These additional steps allow for the identification and separation of horizontal slab elements, such as floors and ceilings, from other interior and exterior building elements. This differentiation is essential for various applications in architecture, engineering, and construction, such as structural analysis, acoustic design, and vibration control. By generating well-defined horizontal slab elements, professionals can better assess and optimize these elements for factors like load-bearing capacity, deflection, and thermal performance. Additionally, this information can be valuable for designing and detailing floor and ceiling systems, including finishes, insulation, and service integrations.

In a further step 210, the method of the invention is further refined to generate and classify interior wall elements of the building. This achieved by classifying each solid cell that is neither classified as an exterior shell building element nor as a horizontal slab element as a member of an interior wall element on condition that the solid cell is located between vertical faces of two piecewise planar objects. Such a solid cell is named interior wall solid cell 108. The interior wall solid cells 108 are subsequently merged into a group of interior wall elements.

These additional steps allow for the identification and separation of interior wall elements from other building elements, such as exterior walls, roofs, and horizontal slabs. This differentiation is essential for various applications in architecture, engineering, and construction, such as space planning, structural analysis, and acoustic design. By generating well-defined interior wall elements, professionals can better assess and optimize these elements for factors like load-bearing capacity, sound insulation, and fire resistance. Additionally, this information can be valuable for designing and detailing interior wall systems, including finishes, insulation, and service integrations.

In a further step 211, the solid modelling method is further refined to identify and group interior wall elements 109 that belong to the same interior wall. This is achieved by calculating a connectivity graph in which the faces of the corresponding piecewise planar objects contributing to the interior wall elements are represented as nodes. These nodes are connected with an edge if the faces are parallel, partially overlapping, and not further apart from each other than two times the user-defined thickness. Classify the interior wall elements as being part of the same interior wall 109 on condition that their geometric center is located between any pair of faces of piecewise planar objects which are interconnected by edges in said connectivity graph.

These additional steps allow for the logical grouping of individual interior wall elements that form a continuous interior wall within the building model. This grouping is beneficial for various applications in architecture, engineering, and construction, such as space planning, structural analysis, and material estimation. By accurately identifying and grouping interior wall elements, professionals can better understand the overall layout of the building, optimize the design for factors like load distribution and spatial functionality, and efficiently manage the construction process by generating accurate bills of materials and coordinating the installation of wall systems.

In a further and last step 212, the method of the invention is extended to classify and attribute any remaining unclassified solid cells to the most appropriate interior wall element based on a depth-first search algorithm. Each of the solid cells that are not yet classified as being part of a classified building element (e.g., exterior shell, horizontal slab, or interior wall) are attributed to one of the interior wall elements 109 by performing a depth-first search that is initiated from a neighbouring interior wall element in the direction of the solid cell. The depth-first search is performed in a horizontal direction.

These additional steps allow for the classification and attribution of any remaining unclassified solid cells, which might represent smaller or irregular interior wall segments, to the most suitable interior wall element within the building model. By using a depth-first search algorithm in a horizontal direction, the method ensures that the unclassified solid cells are systematically evaluated and assigned to the nearest or most relevant interior wall element.

This process improves the overall accuracy and completeness of the building model by accounting for all solid cells, including those that might have been initially unclassified or difficult to classify. It also enables better integration of the building model with other design, analysis, and construction tools, as well as more accurate material estimation and construction planning.

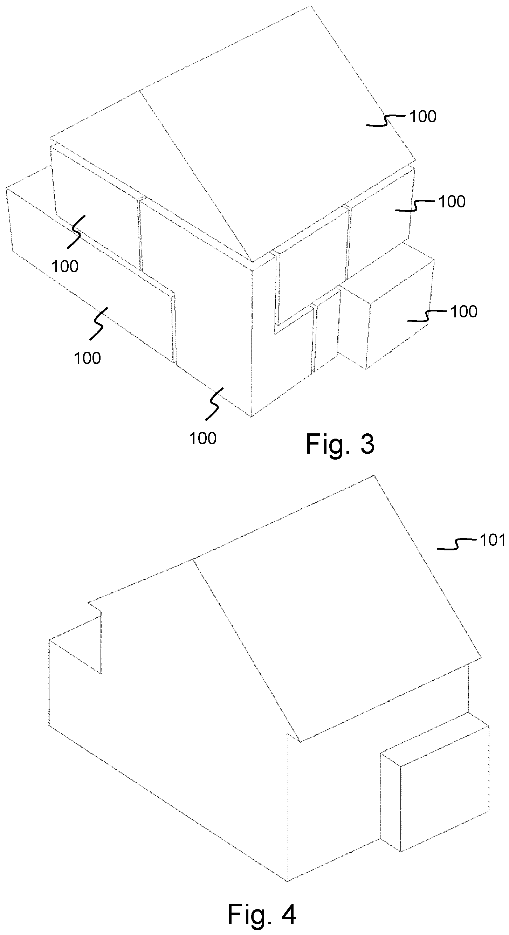

Fig. 3 is an illustration of the set of piecewise planar objects 100 that are used as input for the method of the invention. The individual piecewise planar objects 100 each represent a room interior volume that is obtained from scanning the room and by subsequently processing the scans to obtain a simplified model of the room interior. This simplified room model has to be a piecewise planar object 100. Each piecewise planar object 100 therefore is a closed volume that does not overlap with any of the other piecewise planar objects 100.

Fig. 4 illustrates the results of the first steps in the method of the invention. In a first step 201, all faces from all piecewise planar objects 100 of the set are extruded in the perpendicular direction of the object surface with a user defined thickness. In other words, each piecewise planar object is grown by extruding the planes of said piecewise planar objects with a user defined thickness.

The user defined thickness is chosen to represent a typical thickness of a wall. Preferably, this user defined thickness is the thickness of an exterior wall. Growing the piecewise planar objects with the thickness of an exterior wall, ensures that the exterior shell receives a realistic thickness.

The grown or extruded piecewise planar objects are then merged together into a fused piecewise planar object 101 as depicted in step 202.

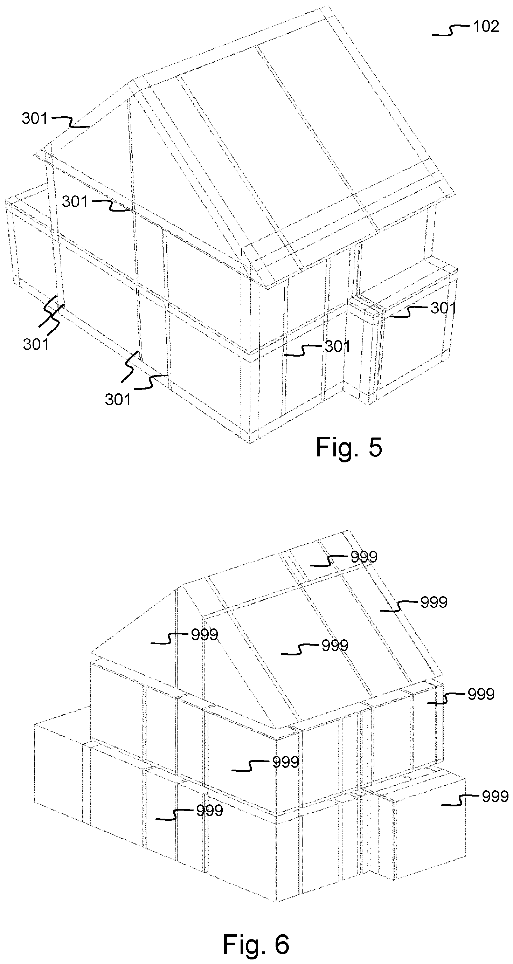

Fig. 5 illustrates that the obtained volume 101 is subsequently intersected by a number of planes 301 in step 203 of the method. In the drawing, some of the intersections are shown as mainly horizontal and vertical lines marked on the exterior of the fused piecewise planar object as 301. The intersecting planes 301 are obtained by extending the planes that at least run through all faces of said piecewise planar objects 300 and the planes that run through all faces of said fused piecewise planar object 101. Other arbitrarily chosen planes may be added as an intersection. The result of these intersections is a cell complex 102 that comprises a large number of non-overlapping cells, and that make up the complete volume of the fused piecewise planar object 101.

In a next step 204, all cells in the cell complex that were located in a volume represented by any of the original piecewise planar objects 100, are further discarded in the method, and are not considered to be a part of a building element. The discarded cells in this step are the room interior cells which are represented in Fig. 6, and some of them are marked as 999. This means that any cell in the cell complex that was not located in a volume represented by any of the original piecewise planar objects 100, is positively classified as a classified solid cell 103. The cells that are classified as classified solid cells 103 make up all of the building elements that will be extracted, i.e. the interior and exterior walls, the roofs and floors.

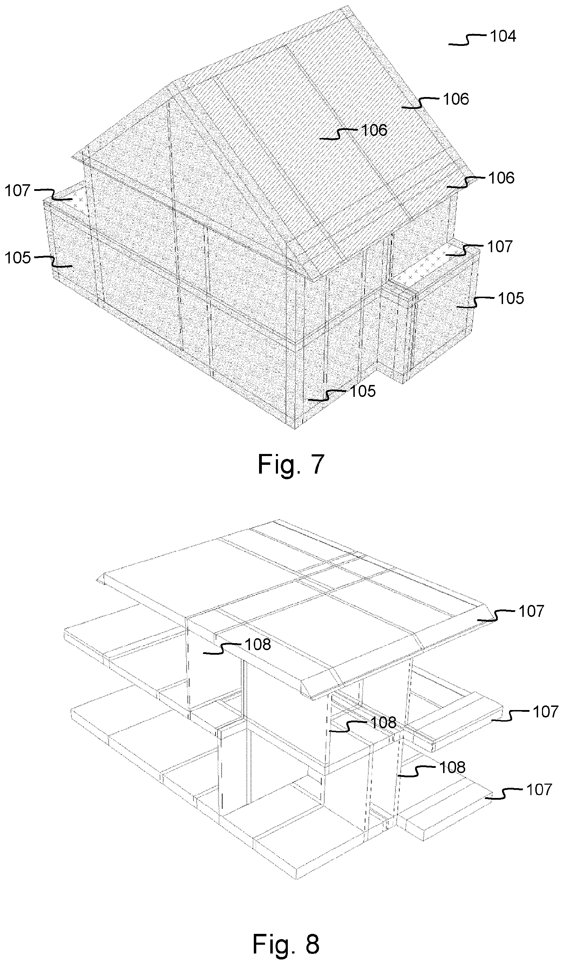

Fig. 7 illustrates the result of how the solid cells that are member of the exterior shell are further attributed to or classified as being a member of a specific type of building element, such as a vertical exterior wall 105, a slanted roof 106 or a horizontal roof or slab 107. In the illustration, each type of building element is indicated with a specific shading. The attribution to a vertical exterior wall of the solid cells that are member of the exterior shell is indicated as 105. The same counts for the attributions to a slanted roof, indicated as 106, and the attributions to a horizontal roof or horizontal slab, indicated as 107.

Fig. 8 illustrates the collection of classified solid cells that remain when removing the exterior building elements as identified in the previous step. The exterior building elements comprise all exterior walls 105, slanted roofs 106 and exterior horizontal roofs or slabs 107. The illustrated remaining volume therefore only still comprises the interior horizontal slabs 107 and the interior walls 108.

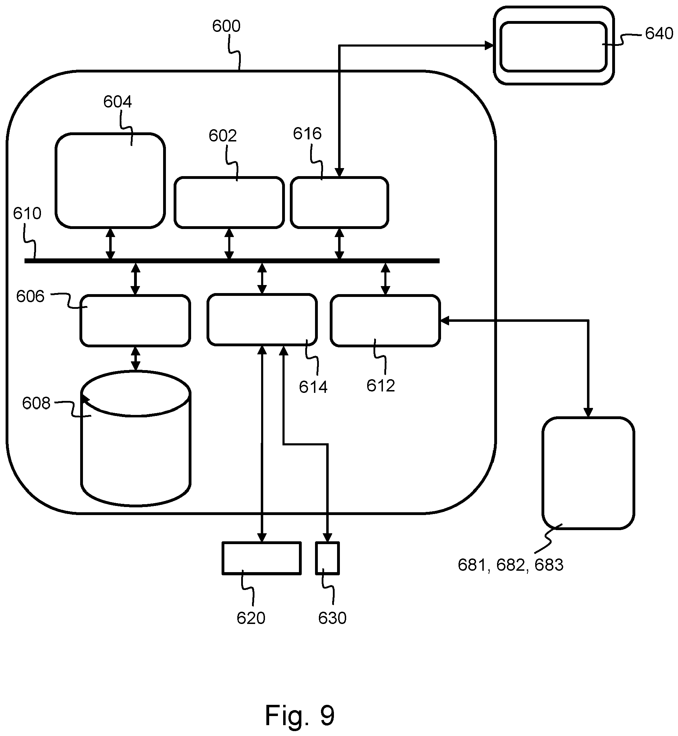

Fig. 9 shows a suitable data processing apparatus 600 enabling to implement embodiments of the method for generating building elements from a set of piecewise planar objects 100 obtained from scanned room interiors of a building. The data processing apparatus 600 may in general be formed as a suitable general-purpose computer and comprise a bus 610, a processor 602, a local memory 604, one or more optional input interfaces 614, one or more optional output interfaces 616, a communication interface 612, a storage element interface 606, and one or more storage elements 608. Bus 610 may comprise one or more conductors that permit communication among the components of the computing system 600. Processor 602 may include any type of conventional processor or microprocessor that interprets and executes programming instructions. Local memory 604 may include a random-access memory (RAM) or another type of dynamic storage device that stores information and instructions for execution by processor 602 and/or a read only memory (ROM) or another type of static storage device that stores static information and instructions for use by processor 602. Input interface 614 may comprise one or more conventional mechanisms that permit an operator or user to input information to the computing device 500, such as a keyboard 620, a mouse 630, a pen, voice recognition and/or biometric mechanisms, a camera, etc. Output interface 616 may comprise one or more conventional mechanisms that output information to the operator or user, such as a display 640, etc. Communication interface 612 may comprise any transceiver-like mechanism such as for example one or more Ethernet interfaces that enables computing system 600 to communicate with other devices and/or systems, for example with other computing devices 681, 682, 683. The communication interface 612 of computing system 600 may be connected to such another computing system by means of a local area network (LAN) or a wide area network (WAN) such as for example the internet. Storage element interface 606 may comprise a storage interface such as for example a Serial Advanced Technology Attachment (SATA) interface or a Small Computer System Interface (SCSI) for connecting bus 610 to one or more storage elements 608, such as one or more local disks, for example SATA disk drives, and control the reading and writing of data to and/or from these storage elements 608. Although the storage element(s) 608 above is/are described as a local disk, in general any other suitable computer-readable media such as a removable magnetic disk, optical storage media such as a CD or DVD, -ROM disk, solid state drives, flash memory cards, ... could be used.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. Computer implemented method for generating building elements from a set of piecewise planar objects (100) obtained from scanned room interiors of a building, comprising the steps of:
- growing said piecewise planar objects (100) by extruding the planes of said piecewise planar objects with a user defined thickness,
- obtaining a fused piecewise planar object (101) by creating a union of said grown piecewise planar objects representing said room interiors,
- obtaining a cell complex (102) comprising cells that are obtained by intersecting said fused piecewise planar object (101) with intersecting planes (301) that are obtained by extending all planes of said piecewise planar objects and all planes of said fused piecewise planar object,
- classifying each cell of said cell complex as a solid cell (103) on condition that said cell is not located within one of said piecewise planar objects,
- merging said solid cells into said building elements.

2. The method of claim 1 further comprising the steps of:
- further classifying each of said solid cells (103) as a member of an exterior shell of said building, on condition that an orthogonal distance between a geometric centre of said solid cell and a plane of said fused piecewise planar object does not exceed said user defined thickness,
- merging said solid cells that are classified as a member of an exterior shell of said building into an exterior shell building element.

3. The method of claim 2 further comprising the steps of:
- further classifying each of said solid cells of said exterior shell building element as a member of a vertical exterior wall element (105) of said building, on condition that said solid cell shares an exterior face with said fused piecewise planar object and that said exterior face is oriented vertically,
- merging said solid cells that are classified as a member of said vertical exterior wall element of said building into a vertical exterior wall element.

4. The method of claim 3 further comprising the steps of:
- further classifying each of said solid cells of said exterior shell building element as a member of a roof element (106) of said building, on condition that said solid cell shares an exterior face with said fused piecewise planar object and that said exterior face is oriented upwards,
- merging said solid cells that are classified as a member of said roof element of said building into a roof element.

5. The method of claim 4 further comprising the steps of:
- further classifying each of said solid cells that are not classified as said exterior shell building element as a member of a horizontal slab element (107) of said building, on condition that said solid cell shares an upper face with a lower horizontal plane of a piecewise planar object, or that said solid cell shares a lower face with an upper horizontal plane of a piecewise planar object,
- merging said solid cells that are classified as a member of an horizontal slab element of said building into a horizontal slab element.

6. The method of claim 5 further comprising the steps of:
- further classifying each of said solid cells that are neither classified as said exterior shell building element, nor as horizontal slab element as a member of an interior wall element (108) of said building, on condition that said solid cell is located between vertical faces of two piecewise planar objects,
- merging said solid cells that are classified as a member of an interior wall element of said building into an interior wall element,

7. The method of claim 6 further comprising the steps of:
- further classifying each of said interior wall elements as being part of a same interior wall by calculating a connectivity graph wherein the faces of the corresponding piecewise planar objects that are contributing to said interior wall elements are represented as nodes, and wherein these nodes are connected by an edge on condition that said faces are parallel, partially overlapping, and not further apart from each other than two times said user defined thickness,
- classifying said interior wall elements as being part of a same interior wall on condition that their geometric center is located between any pair of faces of piecewise planar objects which are interconnected by edges in said connectivity graph.

8. The method of claim 7 further comprising the steps of further classifying each of said solid cells that are not classified yet as being part of a classified building element, and to attribute said solid cell to one of said interior wall elements by performing a depth-first search that is initiated from a neighbouring interior wall element in the direction of said solid cell, and wherein said depth-first search being performed in a horizontal direction.

9. The method according to any of the preceding claims comprising the step of adding the building elements classification as BIM data to each classified building element.

10. A data-processing apparatus comprising means for carrying out the method of any one of the preceding claims.

11. A computer program product comprising instructions which, when the program is executed by a computer, cause the computer to carry out the method of any one of the preceding claims.

12. A computer readable medium comprising instructions which, when the program is executed by a computer, cause the computer to carry out the method of any one of the preceding claims.
